Europäisches Patentamt

(19) European Patent Office

Office européen des brevets

(11) Publication number: **0 204 855 B1**

# (12) EUROPEAN PATENT SPECIFICATION

(45) Date of publication of patent specification: **04.03.92** (51) Int. Cl.⁵: **G01N 23/225**, **H01J 37/256**

(21) Application number: **85107189.4**

(22) Date of filing: **11.06.85**

(54) **Method and apparatus for state analysis.**

(43) Date of publication of application:
**17.12.86 Bulletin 86/51**

(45) Publication of the grant of the patent:
**04.03.92 Bulletin 92/10**

(84) Designated Contracting States:
**DE FR GB**

(56) References cited:
**US-A- 3 909 612**

**SIEMENS ZEITSCHRIFT, vol. 49, no. 11, 1975, pages 732-739, Munich, DE; H. REHME et al.: "Spektroskopische Methoden zur Mikroanalyse im Rasterelektronen-mikroskop"**

**ANALYTICAL CHEMISTRY, vol. 46, no. 14, December 1974, pages 2234-2237; R.G. HURLEY et al.: "New soft X-ray method for determining the chemical forms of sulfur in coal"**

**PATENTS ABSTRACTS OF JAPAN, vol. 4, no. 188 (P-42) [670], 24th December 1980; & JP - A - 55 129 735 (NIPPON DENSHI K.K.) 07-10-1980**

**X-RAY SPECTROMETRY, vol. 12, no. 1, 1983,**

**pages 47-49, Wiley Heyden Ltd.; H. EBEL et al.: "An X-ray spectrometer with a position-sensitive wire detector (PSD)**

**APPLIED SPECTROSCOPY, vol. 35, no. 2, March-April 1982, pages 171-174, Baltimore, Maryland, US; Y. GOHSHI et al.: "Wide range two-crystal vacuum X-ray spectrometer for chemical state analysis"**

**B.K. AGARWAL: "X-ray spectroscopy, an introduction", 1979, pages 258-269, Chapter 6.2, Springer-Verlag, Berlin, DE; "Chemical shifts of emission lines"**

(73) Proprietor: **SHIMADZU CORPORATION**
**378, Ichinofunairi-cho Kawaramachi-dori Nijo Sagaru**
**Nakagyo-ku Kyoto 604(JP)**

(72) Inventor: **Soezima, Hiroyoshi**
**28, Sirie, Oyamazaki-cho**
**Otokuni-gun Kyoto-fu(JP)**

(74) Representative: **TER MEER - MÜLLER - STEINMEISTER & PARTNER**
**Mauerkircherstrasse 45**
**W-8000 München 80(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### Field of the Invention

The present invention relates to an apparatus for analyzing the chemical bonding state of an element, e. g. for analyzing whether Si or $SiO_2$ is present.

### Description of the Prior Art

An article by R. G. Hurley and E.W. Shite in Analytical Chemistry, Vol. 46, Nr. 14, December 1974, pages 2234-2237 with the title "New Soft X-Ray Method for Determining the Chemical Forms of Sulfur in Coal" describes an apparatus having the following features:

- exciting means for exciting the emission of characteristic X-rays from an element,
- spectrometer means for measuring with a single spectrometer the intensities of the characteristic X-rays at four predetermined wavelengths, one after the other, and
- evaluating means for calculating intensity ratios of the signals as measured by said spectrometer means at said wavelengths, for determining the chemical bonding state from the ratios.

Whereas the just mentioned apparatus performs measurements at the four predetermined wavelengths one after the other, an apparatus as described in an article by H. Rehme and E. Wolfgang in Siemens-Zeitschrift 49(1975), Vol. 11, pages 732-739 with the title "Spektroskopische Methoden zur Mikroanalyse im Rasterelektronenmikroskop" acquires a complete spectrum by use of an energy dispersive spectrometer. However, the authors mention that the resolution of an energy dispersive spectrometer is only sufficient for distinguishing different elements from each other; it is not sufficient to distinguish different bonding states of a single element.

A similar apparatus, however not for analyzing the chemical bonding state of an element, is described in US-A-3,909,612. It uses a plurality of spectrometers, one for each predetermined wavelength. The apparatus serves for detecting the presence of different elements in a probe. For to decide whether e.g. two predetermined metals are present, two wavelengths are predetermined, whereby each of the two wavelengths is set to a maximum emission wavelength of one of the two metals. The ratio between intensities of signals of the first and second wavelength, respectively, is high in regions where the first metal is present, whereas it is low in regions where the second metal is present.

A special realization of a wavelength dispersive spectrometer is the so-called PSD(Position Sensitive Detector)-spectrometer. One kind of such spectrometer is described in an article by H. Ebel et al. in X-RAY SPECTROMETRY, Vol. 12, No. 1, 1983, pages 47-49 under the title "An X-Ray Spetrometer with a Position-Sensitive Wire Detector (PSD)".

It is the object of the present invention to provide a simply contructed apparatus for analyzing the chemical bonding state of an element on an extended sample in real-time. The apparatus of claim 1 realizes the object of the invention.

Due to the scanning means and the simultaneous measurement at two predetermined wavelengths, line analysis or two-dimensional analysis of the chemical bonding state of an element can be performed in real-time.

The present invention will become more fully understood from the detailed description given herein below illustrated by the accompanying figures in which:

Figs. 1 through 4 are graphs of spectra of characteristic X-rays used for explaining a method of the present invention;

FIG.5 is a schematic arrangement of a state analysis apparatus according to a first preferred embodiment of the present invention;

FIGS.6 through 8 are block diagrams of the state analysis apparatus of FIG.5 to process state detection signals;

FIG.9 is a schematic arrangement of a state analysis apparatus according to a second preferred embodiment of the present invention; and

FIG.10 is a block diagram of the state analysis apparatus of FIG.9 to process state detection signals.

## DESCRIPTION OF THE PREFERRED EMBODIMENTS

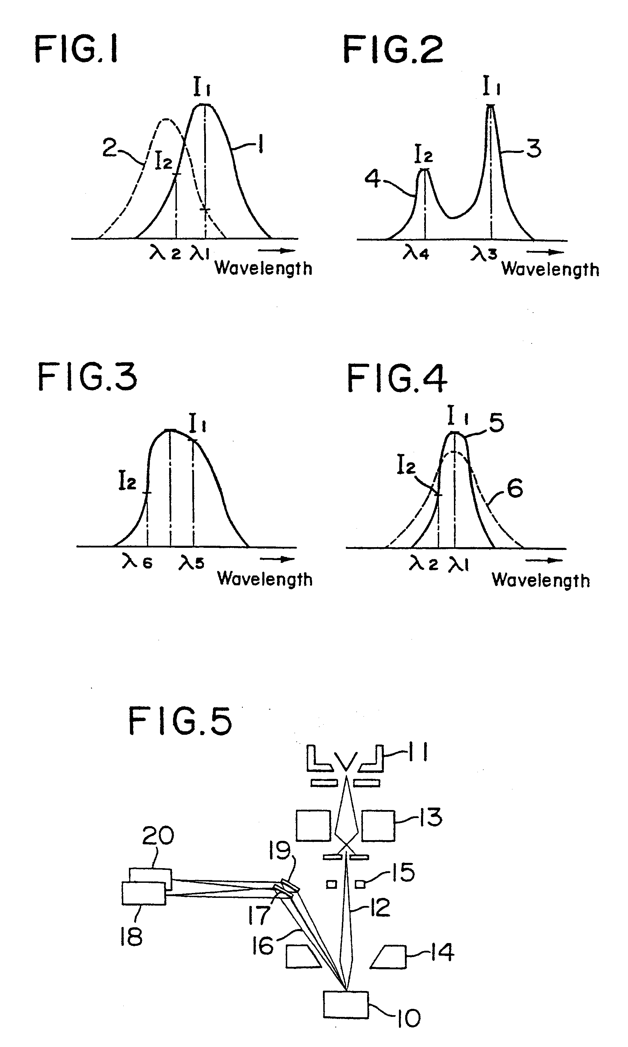

FIGS.1 through 4 are graphs of spectra of characteristic X-rays used for explaining a method of the present invention.

FIG.1 shows spectra of characteristic X-ray of Si element or $SiO_2$, for example, contained in the specimen. The changing from Si to $SiO_2$ enables the shift of the peak wavelength in the spectra of the characteristic X-rays. When the element of Si is in a first state to be metallic Si, it provides spectra 1 of FIG. 1 as the inherent characteristic X-rays. In the spectra 1, the peak wavelength value is $\lambda_1$. A wavelength value far from $\lambda_1$, at about a half of half width (at most at the peak half width) is $\lambda_2$. Since the values of $\lambda_1$ and $\lambda_2$ are previously known depending on an element to be analyzed, two spectrometers are set to the wavelengths $\lambda_1$ and $\lambda_2$, respectively. When the two spectrometers detect the spectra, the intensity detected is given to

he $I_1$ and $I_2$. It is assumed that they satisfy the following relation.

$$I_1 \geqq \alpha\beta_1 I_2 \qquad (1)$$

$\alpha$ is an inherent factor so that the sensitivity of a first spectrometer for measuring the intensity $I_1$ at the wavelength $\lambda_1$ becomes equal to that of a second spectrometer for measuring the intensity $I_2$ at the wavelength $\lambda_2$. The factor $\alpha$ is defined according to the spectrometers. $\beta_1$ is a factor represetative of the wavelength shift amount in the characteristic X-ray spectra, the factor being defined with corresponding to the specific state of the element to be analyzed.

In a second state of the Si element, it is a compound of, for example, $SiO_2$. The spectra of the Si element in this second state is shifted toward the shorter wavelengths due to the effect of oxygen to be spectra 2, far from spectra 1. The peak wavelength value of the spectra 2 is thereby shifted toward the shorter wavelengths.

When the two spectrometers set to the wavelengths $\lambda_1$ and $\lambda_2$ are used to detect the characteristic X-ray spectra in the second state, the intensity $I_1$ and $I_2$ satisfy the following relation.

$$I_1 < \alpha\beta_1 I_2 \qquad (2)$$

Therefore, the characteristic X-rays of the element to be analyzed are detected based on the wavelengths $\lambda_1$ and $\lambda_2$ previously selected in order to compare the detected intensity data with each other. To detect the first state of the element $S_1$, state detection signals are outputted in connection with only some measurement points providing the intensity ratio for satisfying the relation (1), so that a line analysis or a two-dimensional scanning image in the first state can be displayed. To detect the second state of the combination of Si with O, namely $SiO_2$, state detection signals are outputted from only some measurement points providing the intensity ratio for satisfying the inequality (2), so that the line analysis or the two-dimensional scanning image in the second state can be displayed, also.

FIG. 2 shows a graph of spectra of the characteristic X-rays where the intensity ratio of the related peaks are changed depending on the specific state such as the chemical bonding, for example, in the case of $L\alpha$ and $L\beta$ of Fe or $\alpha_3$ and $\alpha_4$ of K satellites.

Two spectrometers are set to peak wavelengths $\lambda_3$ and $\lambda_4$ of the two related peaks 3 and 4. In the first state, the detected intensity data $I_1$ and $I_2$ of the characteristic X-rays at the selected wavelengths $\lambda_3$ and $\lambda_4$ are assumed to satisfy the following relation.

$$I_1 \geqq \alpha\beta_2 I_2 \qquad (3)$$

In the second state, the intensity data $I_1$ and $I_2$ are assumed to satisfy the following relation.

$$I_1 < \alpha\beta_2 I_2 \qquad (4)$$

$\beta_2$ is a factor representative of the intensity ratio of the related peaks. The line analysis or the two-dimensional scanning image specific to the states can be given by determining whether the spectra of the characteristic X-rays at the measurement points belong to either of the relations (3) and (4).

FIG. 3 shows a graph of spectra of the characteristic X-rays wherein symmetry in the spectra is changed depending on the change of the state such as the chemical bonding states. The two spectrometers are set to wavelengths $\lambda_5$ and $\lambda_6$, respectively, which are, for example, about a half of the half width, at the longer and shorter wavelength sides. It is detected whether the intensity data of the characteristic X-rays at the selected wavelengths $\lambda_5$ and $\lambda_6$ satisfy one of the following relations.

$$I_1 > \alpha\beta_3 I_2 \qquad (5)$$

$$I_1 < \alpha\beta_3 I_2 \qquad (6)$$

$$I_1 < \alpha\beta_3 I_2 \qquad (7)$$

$\beta_3$ is a factor representative of asymmetry in the spectra of the characteristic X-rays. By detecting one of the relations, the line analysis or the two-dimensional scanning image specific to the state to which the spectra belong can be obtained.

FIG. 4 shows a graph of spectra of the characteristic X-rays where the half width in the spectra of the characteristic X-rays can be altered depending on the changes of the state such as the chemical bonding state. Then it is assumed that the spetra are altered as shown in spectra 5 and 6 depending on the changes of the state, the wavelengths of the two spectrometers should be selected to be $\lambda_1$ of the peak wavelength and $\lambda_2$ far from $\lambda_1$ at about a half of the half width as shown in FIG. 1. The line analysis or the two-dimensional scanning image can be given in the same method as in FIG.1 because the detected intensity ratio can be changed at the selected wavelength if the peak half width of the spectra is changed.

FIG. 5 is a schematic representation of a state analysis apparatus according to a first preferred embodiment of the present invention.

An electron beam 12 emitted from an electron gun 11 is incident upon a measurement point on a sample 10 to be analyzed with a condenser lens 13 and an objective lens 14. A scanning coil 15 is provided for enabling the scanning on the sample 10. In response to the application of the electron beam 12, a characteristic X-ray 16 and secondary electrons are emitted from the sample 10.

In the first preferred embodiment of the present invention, a first and second wavelength dispersive spectrometers are provided to detect the characteristic X-ray 16. The first wavelength dispersive spectrometer comprises a spectroscopic crystal 17 as a wavelength dispersion means and a detector 18. The second wavelength dispersive spectrometer comprises a spectroscopic crystal 19 as a wavelength dispersion means and a detector 20. The two spectrometers with the same sensitivity can detect the characteristic X-rays having the wavelengths specified in FIGS.1 through 4; i.e., one of them is set to $\lambda_1$, $\lambda_3$, or $\lambda_5$, while another to $\lambda_2$, $\lambda_4$, or $\lambda_3$, respectively.

The detectors 18 and 20 may be proportional counters, position sensitive detectors, etc. It is preferable that both spectrometers are positioned adjacently to each other to make a measurement condition similar.

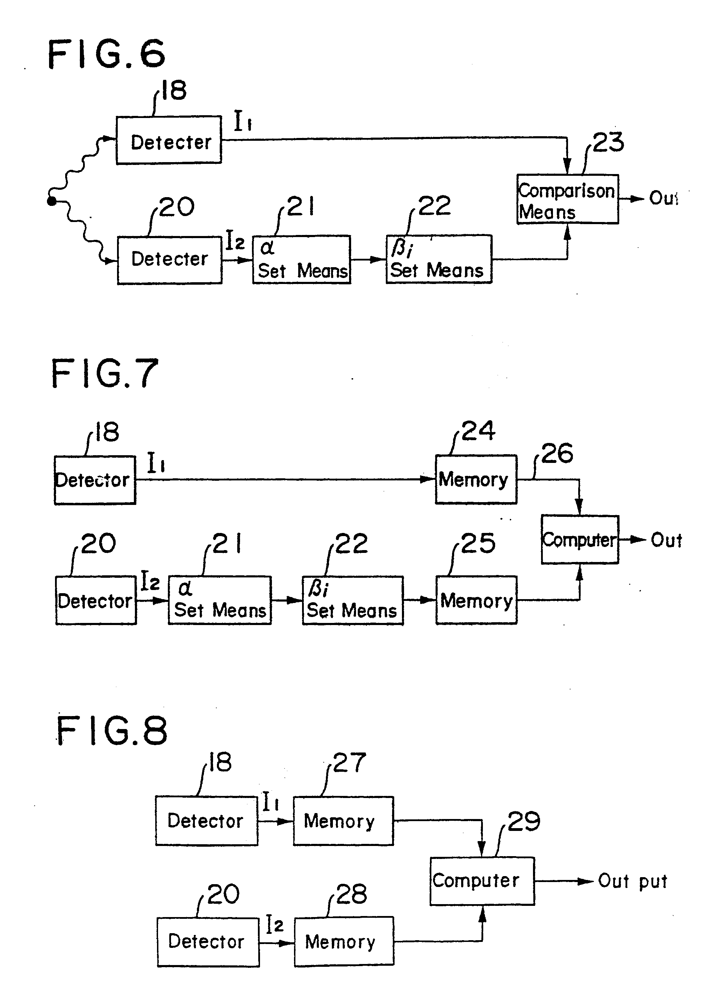

The characteristic X-rays 16 emitted from the sample 10 are dispersed to different wavelengths with the spectroscopic crystals 17 and 19 and are detected by the detectors 18 and 20 at the same time for each scanned position, and sequentially for consecutive scanned positions. It is assumed that the detected intensity of the two detectors 18 and 20 is I, and $I_2$, respectively. The intensity $I_2$ is changed to "$\alpha\beta I_2$" with an $\alpha$ set means 21 and a $\beta i$ ( $i = 1$, 2, or 3 ) set means 22 as FIG. 6 shows. A comparison means 23 is provided for comparing $I_1$, with $\alpha\beta i I_2$ so as to determine whether any specific state is specified. While a plurality of measurement points are scanned with displaying the state detection in a real time on a display, a line analysis or a two-dimensional scanning image can be displayed.

As FIG. 7 shows, the output signals from the detectors 18 and 20 are stored in memories 24 and 25 in the form of the data $I_1$ and $\alpha\beta i I_2$, respectively, together with the position information of the measurement point. Thereafter, a computer 26 is operated to compare the data with each other. Otherwise, as FIG.8 shows, the intensity data $I_1$ and $I_2$ from the detectors 18 and 20 are directly stored in memories 27 and 28 together with the position information of the measurement point. Thereafter, a computer 29 is operated to add the two coefficients $\alpha$ and $\beta i$ and compare the resultant data with each other so as to display the result.

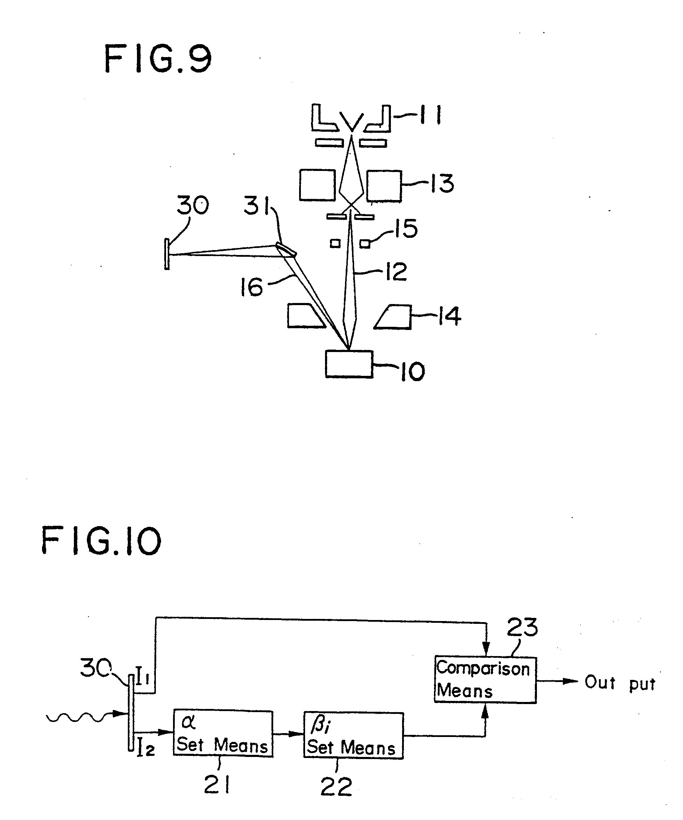

FIG. 9 is a schematic illustration of a state analysis apparatus according to a second preferred embodiment of the present invention. The state analysis apparatus of FIG. 9 is different from that of FIG. 5 in that a single wavelength dispersive spectrometer is provided which comprises a position sensitive detector 30 and a spectroscopic crystal 31 and that the intensity data by the position sensitive detector 30 are detected at two positions; respectively, corresponding to one selected wavelength ( $\lambda_1$ for example ) and another selected wavelength ( $\lambda_2$ for example ).

In case where the two independent spectrometers are provided for measuring the intensity data at the two selected wavelengths $\lambda_1$ and $\lambda_2$, each of them can be placed in a completely spectroscopic condition. On the other hand, in case where only the single spectrometer with the position sensitive detector is provided for simultaneously measuring the intensity data for each scanned position of the sample at two positions of the detector corresponding to the wavelengths $\lambda_1$ and $\lambda_2$, a spectroscopic condition is approximated. This is, however, no problem in practice to compare the intensity data between the adjacent wavelengths.

In the second preferred embodiment, as FIG. 10 shows, two portions of the single position sensitive detector 30 provide the intensity data $I_1$ and $I_2$ in the two different selected wavelengths, simultaneously or sequentially. In FIG. 10, the intensity data $I_1$ and $I_2$ are processed in a real time. Otherwise they are processed after stored within the memories 24, 25, 27, and 28 as shown in FIGS. 7 and 8. A line analysis or a two-dimensional scanning image at the specific state can be thereby displayed.

As described above, in accordance with the present invention, in case where the state of an element contained in a specimen is altered depending on the chemical bonding state, the characteristic X-ray spectra are correspondingly altered in a condition in which a point analysis mode can be applied to analyze the spectra. In such a case, the characteristic X-ray spectra can be effectively separated and altered. A line analysis or a two-dimensional scanning image of a composition distribution in the specimen to be analyzed can be displayed, having the same real time as the conventional case. The capability of the EPMA can be highly expanded beyond the conventional capability only for analyzing the element, in that according to the present invention, the EPMA can afford the important information of the state analysis in analyzing a material.

## Claims

1. An apparatus for analyzing the chemical bonding state of an element of a sample, comprising

   - exciting means (11) for exciting the emission of characteristic X-rays from the element,

- spectrometer means for measuring the intensities of the characteristic X-rays at predetermined wavelengths within the spectrum of the characteristic X-rays generated by said element in a first bonding state,
- and evaluating means for calculating the intensity ratio of the signals as measured by the spectrometer means at said wavelengths, for comparing said calculated intensity ratio with predetermined ratios, and for outputting state detection signals indicating the chemical bonding state depending on the comparison result,

**characterized in that**
- the predetermined wavelengths are two wavelenghts;
- said spectrometer means is arranged to measure the intensities at said both wavelengths simultaneously by a wavelength dispersive arrangement; and
- a scanning means (15) is provided for scanning the samples to perform line analysis or two-dimensional analysis of the sample.

2. An apparatus according to claim 1, characterized in that said spectrometer means comprises two spectrometers.

3. An apparatus according to claim 1, characterized in that said spectrometer means comprises a wave length dispersive spectrometer having a position sensitive detector (30) and a spectroscopic crystal (31), which spectrometer measures said both intensities simultaneously at two position of said position sensitive detector approximated for the both wavelengths.

**Revendications**

1. Dispositif pour analyser l'état de liaison chimique d'un élément d'échantillon, comprenant
- un moyen d'excitation (11) pour exciter l'émission d'un rayonnement X caractéristique depuis l'élément,
- un moyen de spectrométrie pour mesurer les intensités du rayonnement X caractéristique à des longueurs d'onde prédéterminées dans le spectre du rayonnement X caractéristique produit par ledit élément dans un premier état de liaison,
- et un moyen d'évaluation pour calculer le rapport des intensités des signaux d'après les mesures faites auxdites longueurs d'onde par le moyen de spectrométrie, pour comparer ledit rapport des intensités calculé avec des rapports prédéterminés, et pour produire des signaux de détection d'état indiquant l'état de liaison chimique en fonction du résultat de la comparaison,

caractérisé en ce que
- les longueurs d'onde prédéterminées sont deux longueurs d'onde;
- ledit moyen de spectrométrie est agencé pour mesurer simultanément les intensités desdites deux longueurs d'onde par un agencement à dispersion de longueurs d'onde, et
- un moyen de balayage (15) est prévu pour balayer les échantillons afin d'effectuer une analyse linéaire ou une analyse en deux dimensions de l'échantillon.

2. Dispositif selon la revendication 1, caractérisé en ce que ledit moyen de spectrométrie comprend deux spectromètres.

3. Dispositif selon la revendication 1, caractérisé en ce que ledit moyen de spectrométrie comprend un spectromètre à dispersion de longueurs d'onde ayant un détecteur (30) sensible aux positions et un cristal spectroscopique (31), lequel spectromètre mesure simultanément lesdites deux intensités dans deux positions dudit détecteur sensible aux positions, avec une approximation pour les deux longueurs d'onde.

**Patentansprüche**

1. Vorrichtung zum Analysieren des chemischen Bindungszustandes eines Elements in einer Probe, mit
- einer Anregungseinrichtung (11) zum Anregen der Emission charakteristischer Röntgenstrahlung des Elements,
- einer Spektrometereinrichtung zum Messen der Intensitäten der charakteristischen Röntgenstrahlung bei vorgegebenen Wellenlängen innerhalb des Spektrums der von dem Element in einem ersten Bindungszustand erzeugten charakteristischen Röntgenstrahlung, und
- einer Auswerteeinrichtung, welche das Intensitätsverhältnis der von der Spektrometereinrichtung gemessenen Signale bei den Wellenlängen berechnet, das berechnete Intensitätsverhältnis mit vorgegebenen Verhältnissen vergleicht und Zustandsermittlungssignale ausgibt, die den chemischen bindungszustand abhängig vom Vergleichsergebnis anzeigen,

**dadurch gekennzeichnet**, daß

- die vorgegebenen Wellenlängen zwei Wellenlängen sind;
- die Spektrometereinrichtung die Intensitäten bei den zwei Wellenlängen gleichzeitig mit einer wellenlängendispersiven Anordnung mißt; und
- eine Abtasteinrichtung (15) für ein- oder zweidimensionale Analyse der Probe vorhanden ist.

2. Vorrichtung nach Anspruch 1, **dadurch gekennzeichnet**, daß die Spektrometereinrichtung zwei Spektrometer aufweist.

3. Vorrichtung nach Anspruch 1, **dadurch gekennzeichnet**, daß die Spektrometereinrichtung ein wellenlängendispersives Spektrometer mit einem ortssensitiven Detektor (30) und einem spektroskopischen Kristall (31) aufweist, welches Spektrometer die beiden Intensitäten gleichzeitig an zwei Orten des ortssensitiven Detektors mißt, dessen Stellung für die beiden Wellenlängen angenähert ist.

# FIG.I

# FIG.2

# FIG.3

# FIG.4

# FIG.5

# FIG.6

Detecter 18 → $I_1$

Detector 20 → $I_2$ → $\alpha$ Set Means 21 → $\beta_i$ Set Means 22 → Comparison Means 23 → Out

# FIG.7

Detector 18 → $I_1$ → Memory 24 → 26

Detector 20 → $I_2$ → $\alpha$ Set Means 21 → $\beta_i$ Set Means 22 → Memory 25 → Computer → Out

# FIG.8

Detector 18 → $I_1$ → Memory 27

Detector 20 → $I_2$ → Memory 28 → Computer 29 → Out put

# FIG.9

# FIG.10